# EUROPÄISCHE PATENTANMELDUNG

(11) **EP 2 871 670 A1**
(43) Veröffentlichungstag der Anmeldung: **13.05.2015**
(21) Anmeldenummer: 14192301.1
(22) Anmeldetag: 07.11.2014
(51) Int. Cl.: H01L 21/683, H01L 21/762

(54) **Verfahren zum Fixieren von Festkörperplatten**

(30) Priorität: 07.11.2013 DE 102013112245
(71) Anmelder: Siltectra GmbH, 01099 Dresden (DE)
(72) Erfinder: Drescher, Wolfram, 01109 Dresden (DE); Richter, Jan, 01277 Dresden (DE); Schumann, Dirk, 04229 Leipzig (DE)
(74) Vertreter: Lippert, Stachow & Partner

(57) **Zusammenfassung**

Der Erfindung, welche ein Verfahren zum Fixieren von Festkörperplatten (1) betrifft, liegt die Aufgabe zugrunde, eir Verfahren zum Fixieren von Festkörperplatten (1) anzugeben, mit welchem eine Beanspruchung der Oberfläche der Festkörperplatte vermindert wird und welches in einen bestehenden Herstellungsprozessablauf mit geringem Aufwand und Kosten integrierbar ist. Diese Aufgabe wird dadurch gelöst, dass eine Folie (2) mit einer strukturierten Oberfläche (3) bereitgestellt wird, dass zum Verbinden der strukturierten Oberfläche dieser Folie mit der Festkörperplattenoberfläche zwischen diesen eine Verbundmittelschicht (4) eingebracht wird und dass die Folie auf die Festkörperplattenoberfläche aufgepresst wird.

## Beschreibung

Die Erfindung betrifft ein Verfahren zum Fixieren von Festkörperplatten, bei welchem die Festkörperplatte ein Wafer ist, welcher zur Durchführung eines Prozessschritts zumindest auf einer seiner planen Oberflächen mit einer Folie verbunden wird.

Als eine sogenannte Festkörperplatte werden in dieser Beschreibung alle plattenförmigen Gegenstände verstanden, welche aus verschiedenen Materialien oder Materialgemischen bestehen können. In einer speziellen Gestalt dieser Festkörperplatte ist diese ein bei der Herstellung von Halbleiterschaltungen bekannter Wafer aus Silizium, welcher auch vollständige oder teilweise dotierte Bereiche aufweisen kann. Alternativ kann ein Wafer auch in einem oder mehreren vorherigen Fertigungsschritten zumindest teilweise mit einer gewünschten Halbleiterstruktur versehen sein. Aber auch jede andere Festkörperplatte mit einer vorzugsweise planen Oberfläche wird von dieser Beschreibung umfasst, insbesondere für den Fall, dass die Oberfläche der Festkörperplatte empfindlich gegen eine mechanische Beanspruchung ist.

Folien können aus verschiedenen Materialien bestehen und weisen eine sehr geringe Materialdicke auf. Diese können beispielsweise aus einem Kunststoff bestehen und auf einer Rolle aufgerollt oder in Form eines Blatts als Ausgangsmaterial bereitgestellt werden.

Für das hier beschriebene Verfahren ist die Dicke der verwendeten Folie nicht auf typischen Foliendicken im Bereich von unter 0,1 mm beschränkt. Denkbar ist auch eine Verwendung von Platten, beispielsweise aus einem Kunststoff, mit einer Dicke über 0,1 mm, anstelle des hier verwendeten Folien-Begriffs.

In verschiedenen Prozessschritten bei der Herstellung von Silizium-Wafern oder Chips ist es notwendig, beispielsweise den Wafer zum Prozessieren zu fixieren. Hierbei muss der Wafer einerseits gut fixiert werden, andererseits soll aber die Waferoberfläche nicht beschädigt werden.

Hierzu ist bei der Halbleiterherstellung bekannt, ein sogenanntes Selbstklebeband, welches auch als "Dicing-Tape" oder "Dicing-Pad" bezeichnet wird, zur vorübergehenden Fixierung von Silizium-Scheiben, den sogenannten Wafern, auf diese aufzubringen.

Dieses Aufbringen des Selbstklebebandes erfolgt beispielsweise vor dem Herstellungsschritt, in welchem die auf dem Selbstklebeband haftenden Wafer in einzelne Chips zersägt werden.

Hierbei ist es erforderlich, dass die Fixierung des Wafers den Kräften beim Sägen ohne Verschiebung standhält. Bei dem sich anschließenden Vereinzeln der Chips, also dem Ablösen aller Chips vom Selbstklebeband, muss die Klebekraft des Selbstklebebands allerdings so gering sein, dass alle Chips frei von Verunreinigungen und ohne Zerstörungen, beispielsweise an der Oberfläche des Chips, abgelöst werden können.

Ein derartiges Selbstklebeband ist beispielsweise aus der DE 195 20 238 C2 bekannt. Dieses Selbstklebeband zur vorrübergehenden Fixierung von Wafern weist einen für UV-Strahlung durchlässigen Folienträger auf, welcher einseitig mit einer Haftklebemasse beschichtet ist, deren Klebekraft unter Verwendung von UV-Strahlung abgesenkt werden kann.

Weiterhin ist zum Zerteilen von Siliziumkristallen in einzelne Wafer-Scheiben bekannte Draht- oder Diamantdrahtsäge einzusetzen. Hierbei geht aber ein Teil des zum Teil teuren Silizium-Rohmaterials in Form von Spänen verloren.

Die Nachteile dieses Verfahrens bestehen neben dem Materialverlust in Schäden in der Waferoberfläche durch den Sägevorgang, welche mittels zusätzlicher Prozessschritte zur Oberflächenbehandlung, wie beispielsweise Läpp- oder Polierverfahrensschritte beseitigt werden müssen.

Zur Vermeidung dieser Nachteile werden Verfahren eingesetzt, wie beispielsweise in der DE 10 2012 001 620 A1 beschrieben eingesetzt, bei denen zur Herstellung von dünnen Wafer-Scheiben beispielsweise auf eine Folie ein Kleber oder eine Klebeschicht aufgebracht wird. Zwei dieser beschichteten Folien oder alternativ das weiter oben beschriebene Selbstklebeband werden jeweils mit ihrer Klebeschicht auf die Oberseite und die Unterseite des zu bearbeitenden Halbleiter-Werkstücks aufgebracht. Nach dem Aushärten des Klebers wird der Wafer thermisch gestresst. Durch unterschiedliche thermische Eigenschaften von Wafer und Polymer bricht der Wafer in zwei Hälften. Auf beiden dünnen Wafern haftet nunmehr jeweils einseitig noch eine Folie, welche in einem nachfolgenden Schritt von der Waferoberfläche abgelöst werden muss.

Hierfür werden mechanische oder chemische Verfahrensschritte eingesetzt. Nachteilig sind hierbei sowohl die mechanische Beanspruchung der Oberfläche beim Ablösen der Folie, bedingt durch die Haftwirkung des Klebers, welche zu Schäden an der Kristalloberfläche führen kann als auch ein Quellvorgang beim Einsatz von nasschemischen Verfahren zum Ablösen der Folie, welche ebenfalls zu Schäden an der Waferoberfläche führen können.

Werden Folien oder Selbstklebebänder mit Wafern genutzt, welche bereits einige Verfahrensschritte bei der Herstellung durchlaufen haben, können sich diese Probleme noch verschärfen.

Durch die Haftwirkung des eingesetzten Klebers kann es beim Abziehen der Folie speziell an sehr dünnen oberflächennahen Strukturen des Wafers zu Beschädigungen kommen, da an diesen Stellen die Materialdicke beispielsweise bei gängigen Technologien im Bereich von 5 bis 50 µm liegen kann. Derartige Bereiche finden sich an Stellen auf der Waferoberfläche, welche beispielsweise eine Struktur für einen Drucksensor oder ähnliche aufweisen.

Ein weiteres Einsatzgebiet, bei welchem ein Wafer fixiert werden muss, ist das einseitige Abschleifen (grinding) eines Wafers auf eine vorgegebene Dicke, wie beispielsweise aus der DE 10 2008 060 490 A1 und der DE 101 49 721 A1 bekannt ist.

Dieser Prozessschritt des Abschleifens wird meist auf einer Rückseite eines Wafern durchgeführt, wobei auf dessen Vorderseite bereits Halbleiterstrukturen aufgebracht wurden. Somit besteht die Notwendigkeit diesen Wafer auf seiner Vorderseite zu fixieren, wobei es auf dieser Vorderseite zu starken mechanischen Beanspruchungen kommen kann.

Der Nachteil der aus dem Stand der Technik bekannten Verfahren besteht somit in der Gefahr der Beschädigung der Oberflächenstruktur des Wafers durch mechanische Beanspruchungen beim Ablösen der Folie oder des Selbstklebebands.

Der Erfindung liegt somit die Aufgabe zugrunde, ein Verfahren zum Fixieren von Festkörperplatten anzugeben, mit welchem eine Beanspruchung der Oberfläche der Festkörperplatte vermindert wird und welches in einen bestehenden Herstellungsprozessablauf mit geringem Aufwand und Kosten integrierbar ist.

Gemäß der Erfindung wird die Aufgabe bei einem Verfahren zum Fixieren von Festkörperplatten der eingangs genannten Art dadurch gelöst, dass eine Folie, bestehend aus einem einzigen Material, mit einer strukturierten Oberfläche, welche eine Noppen- oder Wabenstruktur aufweist, oder einer Lochstruktur bereitgestellt wird, dass zum Verbinden der strukturierten Oberfläche oder der Lochstruktur dieser Folie mit der Festkörperplattenoberfläche zwischen diesen eine Verbundmittelschicht eingebracht wird und dass die Folie auf die Festkörperplattenoberfläche aufgepresst wird und derart eine formschlüssige Verbindung zwischen der Folie und der Festkörperplatte, welche zumindest entlang der Oberfläche der Festkörperplatte belastbar ist, erzeugt wird.

Gemäß der Erfindung wird eine Folie bereitgestellt, welche zumindest einseitig eine strukturierte Oberfläche aufweist. Diese Struktur kann verschiedenartig ausgeformt werden. Zum Verbinden dieser strukturierten Seite der Folie mit der Oberfläche der Festkörperplatte oder des Wafers wird beispielsweise auf die Oberfläche der Festkörperplatte eine Verbundmittelschicht durch ein geeignetes Verfahren aufgetragen. Das Verbundmittel der Verbundmittelschicht ist nach dem Auftragen noch in seiner flüssigen Form.

Nachfolgend wird die Folie mit ihrer strukturierten Seite auf das aufgetragene Verbundmittel aufgelegt und gegen die Oberfläche der Festkörperplatte gepresst. Bei diesem Pressvorgang strömt das Verbundmittel der Verbundmittelschicht in die Zwischenräume der strukturierten Oberfläche der Folie und füllt diese aus. Derart entsteht eine sich der strukturierten Oberfläche der Folie anpassende Gegenstruktur, bestehend aus dem Verbundmittel der Verbundmittelschicht. Nach dem Aushärten des Verbundmittels entsteht zwischen der Struktur der Folienseite und der Verbundmittelschicht eine formschlüssige Verbindung, welche die Festkörperplatte mit der Folie zusammenhält.

Derart kann der Wafer beispielsweise bei der Durchführung eines Verfahrens, bei dem eine Abspaltung eines dünnen Wafers von einem dickeren Halbleiterausgangsmaterial mittels temperaturinduzierter Spannungen (thermisch gestresst) wie oben beschrieben erfolgt, fixiert werden.

Bei der Durchführung derartiger Verfahren entstehen, hervorgerufen durch die unterschiedlichen Ausdehnungskoeffizienten des Wafermaterials und der Folie, Kräfte, welche vorrangig parallel zur Oberfläche der Festkörperplatte ausgerichtet sind.

Durch die formschlüssige Verbindung zwischen der Struktur der Folie und der ausgehärteten Verbundmittelschicht, sowie damit auch der Festkörperplatte, können diese Kräfte parallel zur Oberfläche der Festkörperplatte optimal übertragen werden.

In einer alternativen Ausführung der Folie weist diese eine Struktur derart auf, dass Löcher oder lochartige Vertiefungen in der Folie bereitgestellt werden.

Auch beim Einsatz derartiger Folien entsteht nach dem Aufpressen auf die Festkörperplattenoberfläche und dem Aushärten des Verbundmittels, welches in die Löcher oder lochartigen Vertiefungen eindringt, eine formschlüssige Verbindung, welche geeignet ist, die beschriebenen Kräfte entlang und parallel der Oberfläche der Festkörperplatte zu übertragen.

In einer Ausgestaltung der Erfindung ist vorgesehen, dass die Verbundmittelschicht als eine Fotolackschicht ausgeführt wird.

Die Verbundmittelschicht kann beispielsweise ein in verschiedenen Prozessschritten bei der Halbleiterherstellung verwendeter Fotolack sein. Alternativ können andere Materialien eingesetzt werden. Hierbei erfolgt die Auswahl alternativer Materialen unter den Gesichtspunkten einer guten Verarbeitbarkeit in verschiedenen

Herstellungsschritten, einer einfachen Möglichkeit des Entfernens des Verbundmittels nach den erwünschten Prozessschritten sowie in einer geringen Adhäsion zwischen dem gewählten Verbundmittel und der Folie.

In einer weiteren Ausgestaltung der Erfindung ist vorgesehen, dass die Strukturierung der Oberfläche auf der Folie derart ausgeführt wird, dass eine Noppen- oder Wabenstruktur erzeugt wird.

Erfindungsgemäß ist vorgesehen, die Folie zumindest auf einer Seite mit eine Struktur zu versehen. In einem dem Verbinden der strukturierten Folie mit der Festkörperplatte vorgelagerten Arbeitsgang wird die Folie derart erzeugt und beispielsweise auf einer Rolle aufgerollt bereitgestellt.

Das zur Strukturierung eingesetzte Material und das Material der Folie ist gleich.

Zur Strukturierung der Folie können verschiedene Formen genutzt werden. Beispielsweise kann eine Einzelstruktur auf der Folie eine Quader-, Zylinder-, Pyramiden-, Tropfen- oder Würfel-Form aufweisen. Dem Fachmann stehen viele weitere Formen zur Verfügung. Vorteilhaft sind all diejenigen Formen, welche von dem Verbundmittel in seinem flüssigen Zustand gut umflossen werden können, damit keine Lufteinschlüsse entstehen. Außerdem muss die Form derart gewählt werden, dass die Folie von der ausgehärteten Verbundmittelschicht abziehbar ist.

In einer besonderen Ausführung der Erfindung ist vorgesehen, dass zusätzlich zu der Verbundmittelschicht eine Opferschicht eingebracht wird.

Zusätzlich zur Verbundmittelschicht kann noch eine weitere Schicht zum Einbringen zwischen die zu verbindenden Oberflächen vorgesehen werden. Beispielsweise kann eine Opferschicht, wie sie aus der Halbleiterherstellung bekannt ist, auf die Festkörperplattenoberfläche aufgebracht werden. In diesem Fall wird die Verbundmittelschicht auf diese Opferschicht aufgetragen und nachfolgend die Folie mit ihrer strukturierten Seite auf die Verbundmittelschicht aufgelegt und aufgepresst. Durch die Verwendung dieser Opferschicht ist die empfindliche Oberfläche der Festkörperplatte zusätzlich geschützt, beispielsweise beim Abziehen der Folie und dem nachfolgenden Entfernen der Verbundmittelschicht nachdem die Arbeitsschritte, welche das Fixieren der Festkörperplatte notwendig gemacht haben, abgeschlossen sind.

In einer Ausgestaltungsform der Erfindung ist vorgesehen, dass die Folie eine Polymerfolie ist.

In einer vorteilhaften Ausführung wird eine strukturierte Polymerfolie eingesetzt. Alternativ können alle Materialen, welche einen elastischen Film ausbilden können, eingesetzt werden.

In einer vorteilhaften Anwendung des Verfahrens erfolgt der Einsatz beim Zersägen oder Spalten eines Wafers in zwei Teilwafer.

In einer anderen Anwendung wird das Verfahren beim Polieren oder Abschleifen eines Wafers eingesetzt.

Das erfindungsgemäße Verfahren kann insbesondere in der Halbleiterherstellung in allen Prozessen eingesetzt werden, in denen ein Wafer fixiert werden soll. Dies gilt besonders für das Zersägen oder Spalten von Wafern aber auch für das Polieren einer Waferoberfläche oder bei einem Abschleifen des Wafers zum Erhalt eines Wafers geringerer Dicke wie dem sogenannten "grinding". Eine Beschränkung der Einsatzmöglichkeiten des beschriebenen Verfahrens auf Prozesse der Halbleiterherstellung liegt nicht vor.

Die Erfindung soll nachfolgend anhand eines Ausführungsbeispiels näher erläutert werden. In den zugehörigen Zeichnungen zeigt
- Fig. 1: eine Darstellung einer zu fixierenden Festkörperplatte und eine erfindungsgemäße strukturierte Folie,
- Fig. 2: eine auf die Oberfläche der Festkörperplatte aufgebrachte Verbundmittelschicht,
- Fig. 3: eine erfindungsgemäße Struktur zum Fixieren eines Wafers,
- Fig. 4: eine Darstellung des Entfernens der Folie von den Oberflächen,
- Fig. 5: eine zusätzlich eingebrachte Opferschicht,
- Fig. 6: eine Möglichkeit der Erfindung, Strukturen auf der Waferoberfläche in die Folienstruktur einzubeziehen,
- Fig. 7: eine Darstellung möglicher Strukturformen der Folie in verschiedenen Ausführungen a) bis d) und
- Fig. 8: eine Darstellung einer Folie mit Löchern als Struktur.

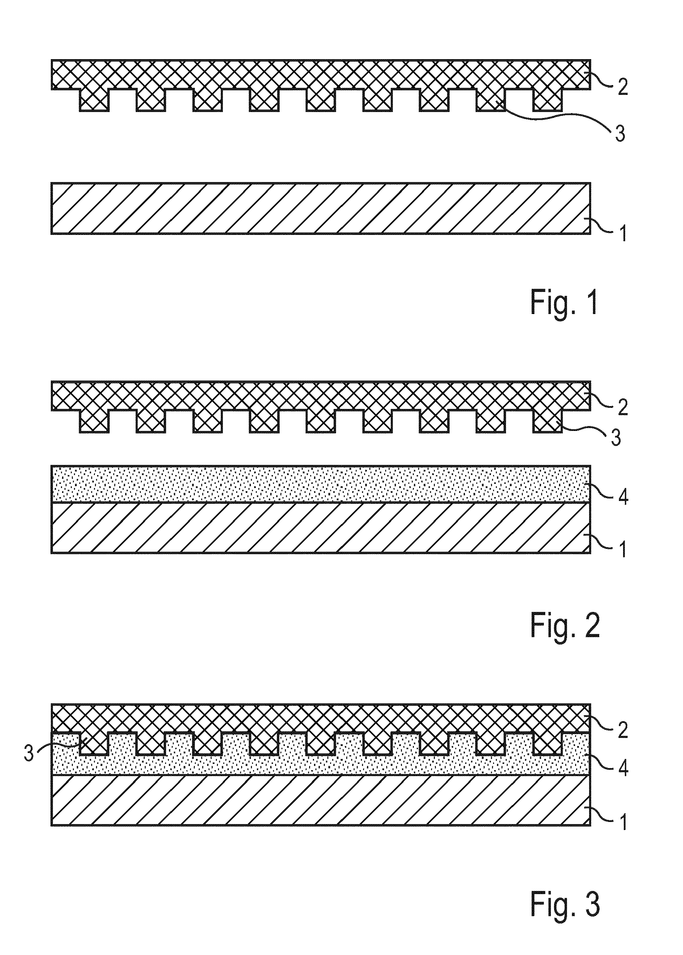

Die Figur 1 zeigt eine Festkörperplatte 1, wie beispielsweise einen Wafer, und eine Folie 2, jeweils in einer Schnittdarstellung. Die Folie 2 weist eine einseitig aufgebrachte Struktur 3 auf. In dieser Ausführung ist in der Schnittdarstellung eine mäanderförmige Ausprägung der Struktur dargestellt, welche beispielsweise durch eine Quader- oder Würfelform der einzelnen Strukturteile der Gesamtstruktur 3 erzeugt wird.

In der Figur 2 ist zusätzlich zu der in der Figur 1 beschriebenen Darstellung eine auf die Oberfläche des Wafers aufgebrachte Verbundmittelschicht 3 dargestellt. Diese kann ein Fotolack oder ein anderes geeignetes Material sein.

Nachfolgend wird die Folie 2 mit ihrer strukturierten Seite 3 auf die Oberfläche der Verbundmittelschicht 4 aufgelegt und mit dem Wafer 1 zusammengepresst. Das Ergebnis dieses Verfahrensschritts ist in der Figur 3 dargestellt. Nach dem Aushärten des Fotolacks 4 entsteht eine formschlüssige Verbindung zwischen der Folienstruktur 3 und dem Fotolack 4. Derart wird der Wafer für nachfolgende Verfahrensschritte, beispielsweise bei der Halbleiterherstellung wie einem Zerteilen von Festkörperplatten oder einem Zersägen des Wafers, fixiert.

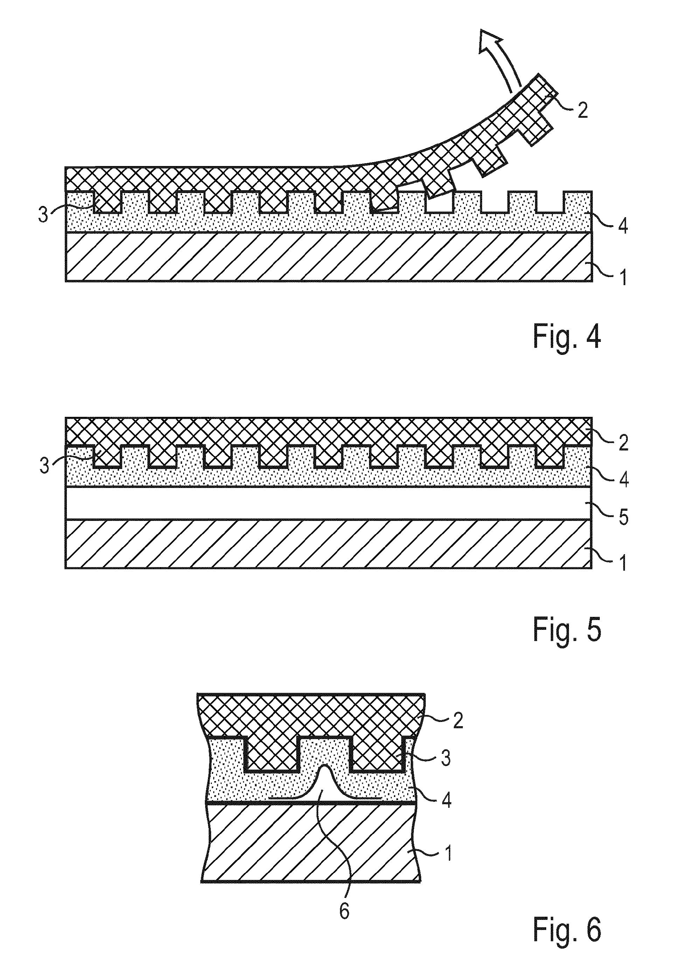

Nach dem Durchlaufen verschiedenartiger Verfahrensschritte wird die Folie 2 durch Abziehen vom Verbundmittel 4 entfernt. Dieser Vorgang ist in der Figur 4 abgebildet. Der in der Figur dargestellte Pfeil soll dabei das Abziehen der Folie 3, in einer Richtung weg von der Festkörperplatte 1, darstellen. Da zwischen dem in der Verbundmittelschicht 4 eingesetzten Fotolack und der Folie 2 nur geringe Adhäsionskräfte auftreten, ist der Kraftaufwand zum Entfernen der Folie gering und eine Beschädigung der Festplattenoberfläche auszuschließen. In einem nachfolgenden nicht dargestellten Verfahrensschritt werden die noch auf der Oberfläche des Wafers befindlichen Reste des Verbundmittels 4 entfernt. Hierzu werden in der Halbleiterfertigung übliche Prozesse verwendet.

In der Figur 5 ist eine bereits zur Figur 3 beschriebene Struktur dargestellt. Zusätzlich wird eine weitere Schicht zwischen der Oberfläche des Wafers 1 und der Folie 2 angeordnet. Dargestellt ist eine zwischen der Oberfläche des Wafers 1 und der Verbundmittelschicht 4 angeordnete Opferschicht 5. Mittels dieser zusätzlichen Schicht soll die Oberfläche des Wafers 1 einen zusätzlichen Schutz erfahren.

In der Figur 6 ist ein besonderer Vorteil der Erfindung abgebildet. Dargestellt ist eine in der Figur 3 beschriebene Struktur in einer gezoomten Darstellung eines Bereiches der Oberfläche des Wafers 1. An dieser Stelle ist eine von der Oberfläche des Wafers 1 hervorstehende Struktur 6 dargestellt, wie sie beispielsweise von einem "Bump", anderen dreidimensionalen mikroelektronischen Strukturen oder Sensoren verursacht werden kann.

Im Stand der Technik ist an diesen Stellen kein Aufbringen einer Folie 2 möglich, da dadurch die Halbleiterstruktur 6 zerstört werden würde. Die erfindungsgemäß strukturierte Folie 2 bietet innerhalb der Struktur 3 Räume in denen das Vorhandensein einer Struktur 6 zu keiner Zerstörung führt.

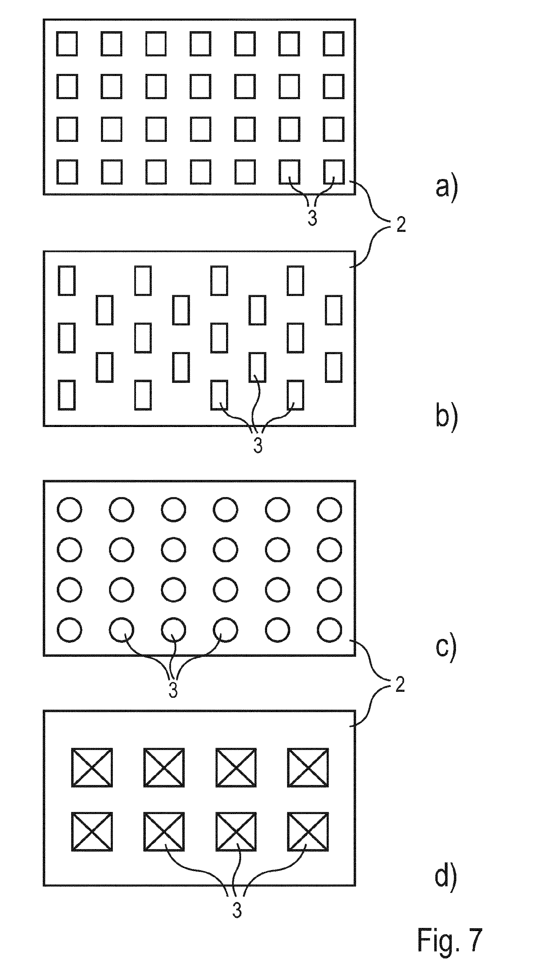

In der Figur 7 sind beispielhaft verschiedene Strukturen 3 auf der Folie 2 dargestellt. Dabei zeigt die Figur 7a eine Würfel-, Figur 7b eine Quader-, Figur 7c eine Zylinder- und die Figur 7d eine Pyramidenstruktur 3 jeweils in einer Ansicht der strukturierten Seite der Folie 2. Eine Beschränkung auf diese Formen ist nicht vorgesehen.

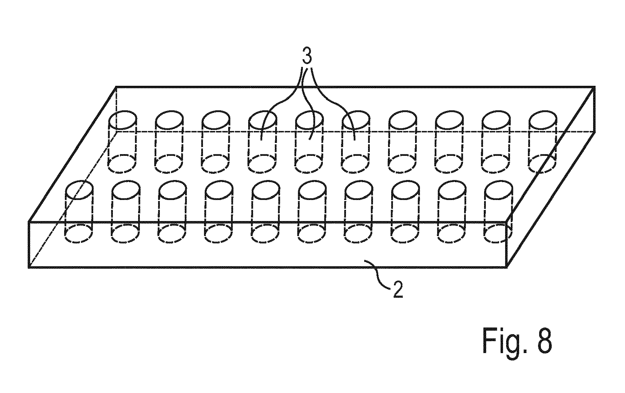

Die Figur 8 zeigt eine alternative Ausführung der Folie 2, welche eine Struktur dadurch ausbildet, dass Löcher in die Folie eingebracht werden. In der Darstellung weisen die Löcher einen kreisrunden Querschnitt auf. Eine Beschränkung auf diese Form ist nicht gegeben. Neben dieser Kreisform sind beliebige n-Eck-Formen möglich, wie beispielsweise die Form eines Dreiecks, Vierecks oder Sechsecks.

### Verfahren zum Fixieren von Festkörperplatten

### Bezugszeichenliste

- 1: Festkörperplatte (Wafer)
- 2: Folie
- 3: Struktur
- 4: Verbundmittelschicht
- 5: Opferschicht
- 6: Waferstruktur (Bump)

## Patentansprüche

1. Verfahren zum Fixieren von Festkörperplatten (1), bei welchem die Festkörperplatte (1) ein Wafer ist, welcher zur Durchführung eines Prozessschritts zumindest auf einer seiner planen Oberflächen mit einer Folie (2) verbunden wird, **dadurch gekennzeichnet, dass** eine Folie (2), bestehend aus einem einzigen Material, mit einer strukturierten Oberfläche (3), welche eine Noppen- oder Wabenstruktur aufweist, oder einer Lochstruktur bereitgestellt wird, dass zum Verbinden der strukturierten Oberfläche (3) oder der Lochstruktur dieser Folie (2) mit der Festkörperplattenoberfläche zwischen diesen eine Verbundmittelschicht (4) eingebracht wird und, dass die Folie (2) auf die Festkörperplattenoberfläche aufgepresst wird und derart eine formschlüssige Verbindung zwischen der Folie (2) und der Festkörperplatte (1), welche zumindest entlang der Oberfläche der Festkörperplatte (1) belastbar ist, erzeugt wird.

2. Verfahren nach Anspruch 1, **dadurch**
**gekennzeichnet, dass** die
Verbundmittelschicht (4) als eine Fotolackschicht ausgeführt wird.

3. Verfahren nach Anspruch 1 oder 2, **dadurch gekennzeichnet, dass** zusätzlich zu der Verbundmittelschicht (4) eine Opferschicht (5) eingebracht wird.

4. Verfahren nach einem der Ansprüche 1 bis 3, **dadurch gekennzeichnet, dass** die Folie (2) eine Polymerfolie ist.

5. Verwendung des Verfahrens nach Anspruch 1 beim Zersägen oder Spalten eines Wafers (1) in zwei Teilwafer.

6. Verwendung des Verfahrens nach Anspruch 1 beim Polieren oder Abschleifen eines Wafers (1).
